# EUROPEAN PATENT APPLICATION

(11) **EP 4 756 390 A1**
(43) Date of publication of application: **10.06.2026**
(21) Application number: 24217015.7
(22) Date of filing: 03.12.2024
(51) Int. Cl.: G01K 7/02, G01K 1/08

(54) **METHOD FOR MANUFACTURING A PROBE ELEMENT AND PROBE ELEMENT FOR A TEMPERATURE MEASURING INSTRUMENT**

(71) Applicant: Endress+Hauser Wetzer GmbH+Co. KG, 87484 Nesselwang (DE)
(72) Inventor: Micieli, Andrea, 20052 Vignate (MI) (IT); Ahmed, Shakil, 20096 Pioltello (IT)
(74) Representative: Endress + Hauser Group Services (Deutschland) AG+Co. KG

(57) **Abstract**

The invention relates to a method for manufacturing a probe element (100) for a temperature measuring instrument with two or more thermocouples. According to the invention, the joining of first pair member conductors (31, 32) and the joining of second pair member conductors (33, 34) is jointly executed in such a way that a single junction (6) with a materially bonded connection between all first member conductors (31, 33) and second member conductors (32, 34) of the first and second pair (3a, 3b) is formed. The invention also relates to a probe element (100) manufactured by the method according to the invention.

## Description

The invention relates to a method of manufacturing a probe element for a temperature measuring instrument, as well as to such probe element.

Temperature measuring instruments or thermometers for determining and/or monitoring the temperature of a medium are known from the prior art in a great variety of embodiments. Thus, there are thermometers which use the expansion of a liquid, a gas or a solid with a known coefficient of expansion, in order to measure temperature, or also others which relate the electrical conductivity of a material, or a quantity derived therefrom, to the temperature, such as electrical resistance when using, for example, resistance elements, or the thermoelectric effect in the case of thermocouples. On the other hand, radiation thermometers, in particular pyrometers, use the heat radiation of a substance to determine its temperature. The underlying measurement principles have each been described in a variety of publications.

In the case of a temperature sensor in the form of a resistance element, so-called thermistors have become known. They are also referred to as PTC or NTC thermistors - short for positive or negative temperature coefficient, respectively. PTC thermistors are particularly suitable as temperature sensors since their resistance increases linearly to first order as the temperature rises. Among the PTC thermistors, platinum is again a preferred material and widely used, since platinum exhibits an overall dependence of resistance on temperature that is at most quadratic. Resistance elements are typically designed to have a certain nominal resistance at a reference temperature of 0°C and are commercially available as so-called Pt10 (10 Ohm), Pt100 (100 Ohm) and Pt1000 (1 kOhm) resistance elements.

The resistance element may be embodied as a so-called wound resistance thermometer or is embodied as a layer mounted on a substrate in thin- or thick film technology. In the case of a thin-film sensor, for example, a sensor element provided with connecting wires and mounted on a carrier substrate is used, wherein the back side of the carrier substrate usually has a metal coating.

In the case of temperature sensors in the form of thermocouples, however, the temperature is determined by a thermoelectric voltage which arises between the unilaterally connected thermowires made of different materials. Thermocouples according to standard IEC 60584-x, e.g., thermocouples of the types R, S, B, J, T, E, K, N, C and A, are usually used as temperature sensors for temperature measurement. However, other pairs of materials, for example those with a measurable Seebeck effect, are also possible. The invention concerns the manufacturing of thermocouple-based probe elements for temperature measuring instruments.

Often, the temperature sensor is arranged in such a probe element, also a so-called measuring insert, comprising an elongated tubular member serving as a sheath for the temperature sensor. The sheath contains e.g. an electrically isolating filler into which the temperature sensor, and at least part of electrical connection lines, which serve for contacting the temperature sensor, are embedded. Typically, for example for an insertion thermometer, the measuring insert protrudes into the medium for the determination of the temperature, starting from a distal end region of the measuring insert. Thus, the distal end region faces the medium and/or dips into the medium and the proximal end region (which is opposite the distal end region in the longitudinal direction of the measuring insert) faces away from the medium. The elongated tubular member is especially closed or sealed off at a distal end region.

The probe element may be assembled in a protective tube acting as a dipping body, especially a metallic protective tube, for example a thermowell. Also, the protective tube is typically sealed off at its distal end, to protect the components, for example the probe element and/or the temperature sensor, against an environment to which the thermometer is exposed, e.g., a medium into which the thermometer is inserted.

For the manufacturing of a probe element with a thermocouple as a temperature sensor element, typically a multi-core mineral insulated metal sheathed (short: MIMS) cable is provided. MIMS cables typically comprise an elongated tubular member with an outer sheath, inside which inner conductors (usually 1 to 8) run, in particular parallel, to the cylindrical axis of the outer sheath.

The outer sheath is typically metallic and may be made of a base or a noble metal, or an alloy (f.e. stainless steel, nickel-based alloy, copper, etc.). The outer sheath typically has an outer diameter in the range 0.5 to 10.8 mm. The inner conductors are insulated from the outer sheath and from each other by means of a compact insulating material, for example by being pressed into a metal oxide powder, e.g. MgO, Al2O3, SiO2 etc. The inner conductors can have different diameters depending on the type of MIMS cable, especially the outer diameter of the outer sheath. Depending on the type of powder, this can be differently hygroscopic and/or strongly pressed, have varying grain sizes, have a different degree of dryness and/or possibly contain chemically bound (residual) water.

The inner conductors are made from different material combinations, which due to the thermoelectric effect, form a (hot) junction of a thermocouple when being joined.

This junction may be embodied either as a so-called grounded thermocouple junction, wherein the inner conductors or cores of the MIMS cable are directly welded to the metallic sheath or as a so-called ungrounded thermocouple junction, wherein the inner conductors or cores of the MIMS cable are electrically insulated from the metallic sheath.

When multiple inner conductors are present, a probe element with multiple temperature sensors can be produced, by joining multiple conductors to form multiple junctions or thermocouples. Typically, the inner conductors of the elongated tubular member are exposed at the distal end. The respective pairs of inner conductors are subsequently joined to form the respective junction of the respective thermocouple, and the distal end is closed off by cap and/or a welded closure, which typically seals the probe element at its distal typ.

In this case, the (hot) junction must be located such that it is spaced at a certain distance from the welding closure. However, the manufacturing of such a probe element with multiple, for example double or triple thermocouples, is almost always manually executed. Thus, the spacing of the hot junctions to the welding closure is subject to fluctuations and may not be uniform for all hot junctions or thermocouples. This can lead to temperature measurement errors when using a probe element produced in such a way, as a measuring insert for a temperature measuring instrument.

It is therefore the object of the invention to provide a simple method for producing a probe element with multiple thermocouples, which are uniformly spaced, i.e. having the same distance, from the distal end.

The object of the invention is solved by a method for manufacturing a probe element for a temperature measuring instrument, as well as by a probe element.

Regarding the method, the object is solved by a method for manufacturing a probe element for a temperature measuring instrument, the method comprising:
- Providing an elongated tubular member having a longitudinal axis, the elongated tubular member comprising:
   -- a sheath;
   -- four or more inner conductors arranged in the interior of the sheath,
      wherein an even number of multiple inner conductors is provided such that the inner conductors are provided in two or more pairs,
      and wherein the pairs of the multiple inner conductors each consist of a first pair member conductor made of a first material and a second pair member conductor made of a second material, wherein the second material is different from the first material; and
   -- an insulating material arranged in the interior of the sheath, which insulating material serves to electrically insulate at least the inner conductors from each other;
- Exposing the inner conductors of pair member conductors to be joined, at a distal end region of the elongated tubular member;
- Joining the first pair member conductor of a first pair with the second pair member conductor of that first pair of the exposed inner conductors, such that a first temperature sensor in form of a thermocouple is produced at the distal end region; and
- Joining the first pair member conductor of a second pair with the second pair member conductor of that second pair of the exposed inner conductors, such that a second temperature sensor in form of a thermocouple is produced at the distal end region,
   wherein the Joining of the first pair member conductors and the Joining of the second pair member conductors is jointly executed in such a way that a single junction with a materially bonded connection between all first member conductors and second member conductors of the first and second pair is formed.

The probe element serves for insertion into a medium, for example when used as a measuring insert of a temperature measuring instrument, in order to determine and/or monitor the temperature of the medium, with or without an additional protective tube.

According to the invention, only a single, common junction between the inner conductors of the pairs is formed. Therefore, all thermocouples are automatically located at the same position and therefore spaced with the same distance to the distal tip formed by the welding closure. The elongated tubular member has, for example 4, 6, 8 or another even number of inner conductors or cores.

The solution according to the invention has the following further advantages:
- An overall easier manufacturing process of the multiple (hot) junctions, with a reduced producing time,
- An increased resistance to mechanical stress, as the single (hot) junction has an overall greater dimension, and
- An overall reduced thermal stress, as only one single welding process for forming the thermocouples is necessary.

In an embodiment of the method, the single junction is a materially bonded connection produced by one of the following
- a welding, brazing, or soldering process.

In an embodiment of the method, the single junction is a materially bonded connection produced by a welding process using one of the following:
- Resistance spot welding,
- Electric Arc welding, especially by using a Tungsten Inert Gas Welding process.

Advantageously, according to the invention, it is possible to use more conventional welding technologies. It is not necessary to employ modern and more complicated and/or costly welding techniques, such as for example laser welding.

In an embodiment of the method, the sheath is metallic, and the insulating material serves to insulate the inner conductors from the sheath.

In an embodiment of the method, six or more inner conductors are provided, and the method further comprises:
- Joining the first pair member conductor of a third pair with the second pair member conductor of that third pair of the exposed inner conductors, such that a third temperature sensor in form of a thermocouple is produced at the distal end region,
   wherein the Joining of the first pair member conductors, the Joining of the second pair member conductors and the Joining of the third pair member conductors is jointly executed in such a way that the single junction comprises a materially bonded connection between all first member conductors and all second member conductors of the first, second, and third pair.

In an embodiment of the method, the elongated tubular member is provided in form of a multi-core mineral insulated metal sheathed cable with an even number of inner conductors.

In an embodiment of the method, it further comprises:
- Closing off the distal end of the sheath with a welded closure, such that a distal tip at the distal end region in the vicinity of the single junction is produced.

In an embodiment of the method, it further comprises:
- Providing a tip insulation material, especially a tip insulation material in form of a powder
- Pressing the tip insulation material against the single junction, before the closing off with the welded closure.

In an embodiment of the method, for one or more of the pairs, the first pair member conductor and the second pair member conductor are arranged within the elongated tubular member, especially within the multi-core mineral insulated metal sheathed cable, if applicable, such that the first pair member conductor is a nearest neighbour to the second pair member conductor.

In an embodiment of the method, the set comprising the following materials:
- the first material of the first pair member conductor of the first pair joined in the single junction;
- the second material of the second pair member conductor of the first pair joined in the single junction;
- the first material of the first pair member conductor of the second pair joined in the single junction;
- the second material of the second pair member conductor of the second pair joined in the single junction;
comprises three or more different materials.

Regarding the probe element, the object is solved by a probe element for a temperature measuring instrument, wherein the probe element is produced by the method according to the invention.

In an embodiment of the probe element, the single junction is spaced from the distal tip of the probe element in a direction along the longitudinal axis by a spacing distance of at least 0.15 times a sheath diameter of the sheath, especially at most 5 times the sheath diameter.

In an embodiment of the probe element, the single junction has a thickness in a direction along the longitudinal axis of at least one times a conductor diameter of the inner conductors, wherein especially the thickness is at most the conductor diameter times a natural multiple corresponding to the total number of the inner conductors, preferably four or six.

In an embodiment of the probe element, the welded closure at the distal tip has a thickness in a direction along the longitudinal axis of at least 0.1 times a sheath diameter of the sheath, especially at most four times the sheath diameter.

In an embodiment of the probe element, an insulation distance, provided by the insulation material between the single junction and the welded closure at the distal tip, has a length in a direction along the longitudinal axis of at least 0.05 times a sheath diameter of the sheath.

The invention is explained in more detail with reference to the following figures, which are not to scale, where identical reference signs denote identical features. Where clarity so requires or it otherwise appears expedient, reference signs already mentioned may be omitted in subsequent figures.

The following are shown:
Fig. 1a shows an embodiment of the probe element 100 according to the invention, in a schematic sectional view, on a plane parallel to a longitudinal axis LA of the elongated tubular member 1;
Fig 1b shows a sectional view of the probe element 100 along the dashed line A-A' in Fig. 1a, wherein, in this embodiment, four inner conductors 31, 32, 33, 34 are present;
Fig 1c shows a sectional view along the dashed line A-A' in Fig. 1a, wherein in this embodiment, six inner conductors 31, 32, 33, 34, 35, 36 are present;
Fig. 2 shows the distal end region 10 of the elongated tubular member 1; and
Fig. 3 shows a flowchart showing steps of the method according to the invention, in one embodiment of the invention.

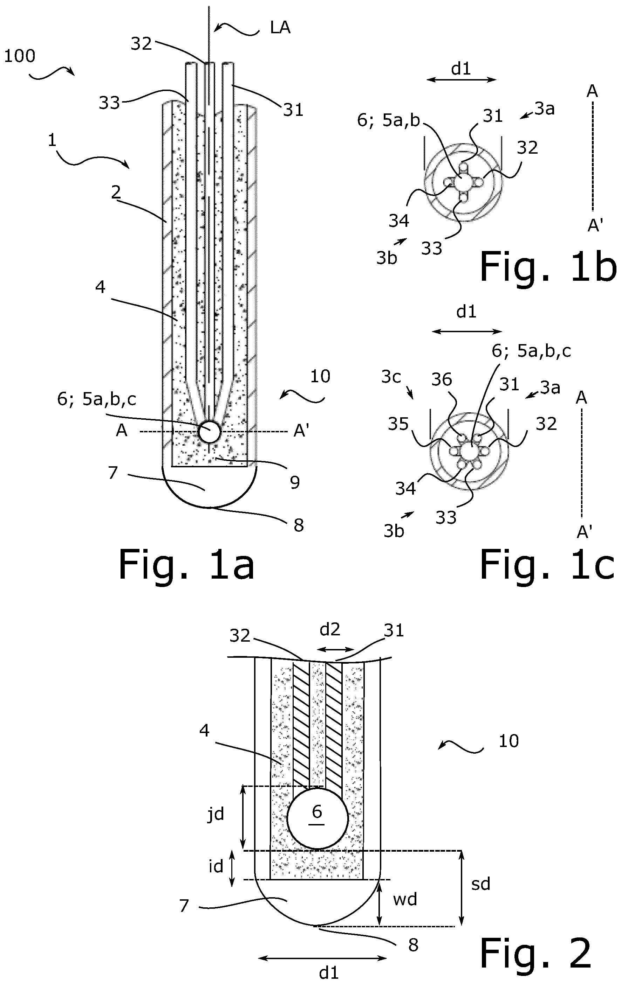

Fig 1a shows the probe element 100 with the elongated tubular member 1 in an embodiment of the invention. The longitudinal axis LA is, for example, a (main) axis of inertia of the elongated tubular member 1. A sheath 2, for example, a metallic sheath 2 contains inner conductors 31, 32, 33, 34; 35, 36, and an insulating material 4 for electrically insulation the inner conductors 31, 32, 33, 34; 35, 36 from each other and from the sheath 2.

In the side view of Fig. 1a, only three inner conductors 31, 32, 33 are visible. There is typically an even number of inner conductors present, for example four inner conductors 31, 32, 33, 34 (see Fig. 1b) or six inner conductors 31, 32, 33, 34, 35, 36 (see Fig. 1c) or even more.

The elongated tubular member 1 is here provided in form of a a multi-core mineral insulated metal sheathed cable (short: MIMS), wherein an even number of cores is selected to provide pairs 3a, 3b; 3c of the inner conductors 31, 32, 33, 34; 35, 36. The pairs 3a, 3b; 3c each have a first pair member conductor 31, 33; 35 of a respective first material and a second member conductor 32, 34; 36 of a respective second material different from the first material. The first materials of all first pair members conductors 31, 33; 35 may or may not be different to each other, the same holds for the second materials of all second member conductors 32, 34; 36.

The respective first and second material of each pair 3a, 3b; 3c is selected such that when being electrically connected, a measurable thermoelectric effect or Seebeck effect between the first pair member conductor and the second pair member conductor is present. Thus, the inner conductors 31, 32, 33, 34; 35, 36 of each pair form the connecting lines for forming a first, second, and, if applicable, third temperature sensor 5a, 5b, 5c in form of a thermocouple, and the probe element 100 can be used for a temperature measuring instrument. These pairs 3a, 3b; 3c of the inner conductors 31, 32, 33, 34; 35, 36 comprise in the case shown in Fig. 1b and 1c in each case next neighbours.

When using the probe element 100 in a temperature measuring instrument, the respective conductors 31, 32, 33, 34; 35, 36 are wired to an electronics unit having operating circuitry. The conductors 31, 32, 33, 34; 35, 36 are wired in such a way, that, for each of the pairs 3a, 3b; 3c, the operating circuitry is embodied to pick up a thermoelectric voltage between the first pair member conductor and the second pair member conductor. Thus, for each of the temperature sensors 5a, 5b; 5c, the respective thermoelectric voltage picked up by the electronics unit serves as a measurement signal which can be used to determine measured values for the temperature present at the at the single junction 6 representing the common location of the respective temperature sensors 5a, 5b; 5c.

At the distal end region 10 of the elongated tubular member 1, all pairs 3a, 3b; 3c are joined together in a single junction 6. This single junction 6 defines the common position of all temperature sensors 5a, 5b; 5c. A welded closure 7 encloses the single junction 6, wherein an additional tip insulation material 9 is provided in the distal end region 10. An outermost distal tip 8 is formed by the welded closure 7 which seals off the sheath 2 at the distal end region 10 of the elongated tubular member 1.

A more detailed view of the distal end region 10 is shown in Fig. 2. The single junction 6 defining the common position of all thermocouple temperature sensors 5a, 5b; 5c has, in the direction of the longitudinal axis LA, a junction thickness jd which is at least one times the conductor diameter d2, i.e. the diameter of the inner conductors 31, 32, 33, 34; 35, 36. An upper limit for the junction thickness jd is in turn typically determined by the number of the inner conductors 31, 32, 33, 34; 35, 36 and by their conductor diameter d2.

As the junction 6 comprises all pairs 3a, 3b; 3c forming the thermocouple temperature sensors 5a, 5b, 5c, the single junction 6 has an overall greater dimension and the corresponding increased resistance to mechanical stress, compared to several single junctions which are individually joined for each pair 3a, 3b; 3b.

The tip insulation material 9 is provided, for example, in form of a powder pressed against the single junction 6 in an amount selected to achieve a certain insulation distance id. The insulation distance id is typically, in the direction along the longitudinal axis LA, a length corresponding to at least 0.05 times the sheath diameter d1 of the sheath 2.

The welded closure 7 forming the distal tip 8 has in turn a weld thickness wd of at least 0.1 times the (external) sheath diameter d1. Both the insulation distance id and the weld thickness wd contribute to a total spacing distance sd of the single junction 6 from the distal tip 8 in a direction along the longitudinal axis LA. Thus, the spacing distance sd is at least 0.15 times the sheath diameter d1.

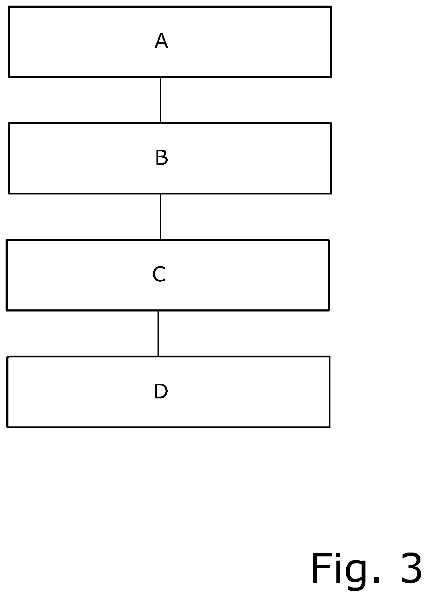

Fig. 3 finally shows a flowchart of step of the method according to the invention, in an embodiment of the invention.

In a step A), the elongated tubular member 1 is provided, for example in form of the aforementioned multi-core mineral insulated metal sheathed (short: MIMS) cable.

In a step B), the pairs 3a, 3b; 3b of the inner conductors 31, 32, 33, 34; 35, 36 to be joined are exposed at the distal end region 10.

In a step C) the single junction 6 between all the inner conductors 31, 32, 33, 34; 35, 36 to be joined is formed, for example by welding the inner conductors 31, 32, 33, 34; 35, 36 together and forming the single junction 6 as a welded joint. Thus, all temperature sensors 5a, 5b; 5c are located substantially at the same position. Thus, for a temperature measuring instrument with a probe element 100 manufactured according to the invention having two or three thermocouple temperature sensors 5a, 5b; 5c there is little or no spatial offset between the multiple temperature sensors 5a, 5b; 5c in particular regarding the lengthwise position, in the direction along the longitudinal axis LA.

In contrast, when forming several individual junctions, i.e. one junction for each of the pairs 3a; 3b; 3c, in particular for a technician employing a manual and thus error-prone welding process, it is difficult to ensure a uniform spacing distance sd for the individual hot junctions to the distal tip 8. An uneven spacing distance sd for the multiple hot junctions may in turn contribute to a systematic error for the determination of the temperature, when using the probe element 100 in a temperature measuring instrument such as mentioned above.

Furthermore, as only one, common welding process must be performed for creating the single, common single junction 6, the (especially thermal) stress stemming from the manufacturing process is minimised. Also, conventional welding techniques such as resistance spot welding or electric arc welding, for example by using a Tungsten Inert Gas Welding process (also known as TIG welding) can be employed. There is no need to employ more sophisticated welding techniques such as laser welding, as it would be necessary when creating several individual junctions.

Finally, in a step D) a tip insulation material 9, for example using a powder as a source material, is pressed against the single junction 6, before enclosing the single junction 6 with a welded closure 7, thereby creating an outermost distal tip 8 of the probe element 100. Similarly, a cap element welded to the sheath 2 could also be used.

The method according to the invention proposes a very simple method to produce a probe element 100 for a temperature measuring instrument, wherein it is ensured in a simple and safe manner that all temperature sensors 5a, 5b, 5c respect the same spacing distance sd extending from the single junction 6 to the distal tip 8. Thus, it can be easily assured for all temperature sensors 5a, 5b; 5c, that the spacing distance sd for the single junction 6 is high enough, i.e. that the spacing distance sd is bigger than a certain minimum value required.

### Reference Signs

- 100: probe element
- 1: elongated tubular member
- 10: distal end region
- 2: sheath
- 31, 32, 33, 34, 35, 36, ...: inner conductors
- 3a, 3b, 3c, ...: pairs of inner conductors
- 4: insulating material
- 5a, 5b, 5c, ...: temperature sensors
- 6: single junction
- 7: welded closure
- 8: distal tip
- 9: tip insulation material

- LA: longitudinal axis
- d1: sheath diameter
- d2: conductor diameter
- jd: junction thickness
- id: insulation distance
- sd: spacing distance
- wd: weld thickness

## Claims

1. Method for manufacturing a probe element (100) for a temperature measuring instrument, the method comprising:
- Providing an elongated tubular member (1) having a longitudinal axis (LA), the elongated tubular member (1) comprising:
-- a sheath (2);
-- four or more inner conductors (31, 32, 33, 34) arranged in the interior of the sheath (2),
wherein an even number of multiple inner conductors (31, 32, 33, 34) is provided such that the inner conductors (31, 32, 33, 34) are provided in two or more pairs (3a, 3b),
and wherein the pairs (3a, 3b) of the multiple inner conductors (31, 32, 33, 34) each consist of a first pair member conductor (31, 33) made of a first material and a second pair member conductor (32, 34) made of a second material, wherein the second material is different from the first material; and
-- an insulating material (4) arranged in the interior of the sheath (2), which insulating material (4) serves to electrically insulate at least the inner conductors (31, 32, 33, 34) from each other;
- Exposing the inner conductors (31, 32, 33, 34) of pair member conductors to be joined, at a distal end region (10) of the elongated tubular member (1);
- Joining the first pair member conductor (31) of a first pair (3a) with the second pair member conductor (32) of that first pair (3a) of the exposed inner conductors (31, 32, 33, 34), such that a first temperature sensor (5a) in form of a thermocouple is produced at the distal end region (10); and
- Joining the first pair member conductor (33) of a second pair (3b) with the second pair member conductor (34) of that second pair (3b) of the exposed inner conductors (31, 32, 33, 34), such that a second temperature sensor (5b) in form of a thermocouple is produced at the distal end region (10),
wherein the Joining of the first pair member conductors (31, 32) and the Joining of the second pair member conductors (33, 34) is jointly executed in such a way that a single junction (6) with a materially bonded connection between all first member conductors (31, 33) and second member conductors (32, 34) of the first and second pair (3a, 3b) is formed.

2. Method according to Claim 1, wherein the single junction (6) is a materially bonded connection produced by one of the following
- a welding, brazing, or soldering process.

3. Method according to Claim 2, wherein the single junction (6) is a materially bonded connection produced by a welding process using one of the following:
- Resistance spot welding,
- Electric Arc welding, especially by using a Tungsten Inert Gas Welding process.

4. Method according to at least one of the previous Claims,
wherein the sheath (2) is metallic, and the insulating material (4) serves to insulate the inner conductors (31, 32, 33, 34) from the sheath (2).

5. Method according to at least one of the previous Claims,
wherein six or more inner conductors (31, 32, 33, 34, 35, 36) are provided, and the method further comprises:
- Joining the first pair member conductor (35) of a third pair (3c) with the second pair member conductor (36) of that third pair (3c) of the exposed inner conductors (31, 32, 33, 34, 35, 36), such that a third temperature sensor (5c) in form of a thermocouple is produced at the distal end region (10),
wherein the Joining of the first pair member conductors (31, 32), the Joining of the second pair member conductors (33, 34) and the Joining of the third pair member conductors (35, 36) is jointly executed in such a way that the single junction (6) comprises a materially bonded connection between all first member conductors (31, 33, 35) and all second member conductors (32, 34, 36) of the first (3a), second (3b), and third pair (3c).

6. Method according to at least one of the previous Claims,
wherein the elongated tubular member (1) is provided in form of a multi-core mineral insulated metal sheathed cable (MIMS) with an even number of inner conductors.

7. Method according to at least one of the previous Claims, further comprising
- Closing off the distal end of the sheath (2) with a welded closure (7), such that a distal tip (8) at the distal end region (10) in the vicinity of the single junction (6) is produced.

8. Method according to Claim 7, further comprising:
- Providing a tip insulation material (9), especially a tip insulation material (9) in form of a powder
- Pressing the tip insulation material (9) against the single junction (6), before the closing off with the welded closure (7).

9. Method according to at least one of the previous Claims,
wherein, for one or more of the pairs (3a; 3b; 3c), the first pair member conductor (31; 33; 35) and the second pair member conductor (32; 34; 36) are arranged within the elongated tubular member (1), especially within the multi-core mineral insulated metal sheathed cable, if applicable, such that the first pair member conductor (31; 33; 35) is a nearest neighbour to the second pair member conductor (32; 34; 36).

10. Method according to at least one of the previous Claims,
wherein the set comprising the following materials:
- the first material of the first pair member conductor (31) of the first pair (3a) joined in the single junction (6);
- the second material of the second pair member conductor (32) of the first pair (3a) joined in the single junction (6);
- the first material of the first pair member conductor (33) of the second pair (3b) joined in the single junction (6);
- the second material of the second pair member conductor (34) of the second pair (3b) joined in the single junction (6);
comprises three or more different materials.

11. Probe element (100) for a temperature measuring instrument, wherein the probe element (100) is produced by the method according to at least one of the previous Claims.

12. Probe element (100) according to Claim 11,
wherein the single junction (6) is spaced from the distal tip (8) of the probe element (100) in a direction along the longitudinal axis (LA) by a spacing distance (sd) of at least 0.15 times a sheath diameter (d1) of the sheath (2), especially at most 5 times the sheath diameter (d1).

13. Probe element (100) according to Claim 11 or 12,
wherein the single junction (6) has a thickness (jd) in a direction along the longitudinal axis (LA) of at least one times a conductor diameter (d2) of the inner conductors (31; 32; 33; 34; 35; 36),
and wherein especially the thickness (jd) is at most the conductor diameter (d2) times a natural multiple corresponding to the total number of the inner conductors (31; 32; 33; 34; 35; 36), preferably four or six.

14. Probe element (100) according to at least one of the Claims 11 to 13,
wherein the welded closure (7) at the distal tip (8) has a thickness (wd) in a direction along the longitudinal axis (LA) of at least 0.10 times a sheath diameter (d1) of the sheath (2), especially at most four times the sheath diameter (d1).

15. Probe element (100) according to at least one of the Claims 11 to 14,
wherein an insulation distance (id), provided by the tip insulation material (9) between the single junction (6) and the welded closure (7) at the distal tip (8), has a length in a direction along the longitudinal axis (LA) of at least 0.05 times a sheath diameter (d1) of the sheath (2).
